# EUROPEAN PATENT APPLICATION

(11) **EP 1 178 532 A2**
(43) Date of publication of application: **06.02.2002**
(21) Application number: 01117532.0
(22) Date of filing: 20.07.2001
(51) Int. Cl.: H01L 27/092, H01L 29/165

(54) **NMOS and PMOS with strained channel layer**

(30) Priority: 24.07.2000 JP 2000222807
(71) Applicant: President of Tohoku University, Sendai 980-8577 (JP)
(72) Inventor: Murota, Junichi, Sendai-shi, Miyagi-ken (JP); Tsuchiya, Toshiaki, Matsue-shi, Shimane-ken (JP); Matsuura, Takashi, Sendai-shi, Miyagi-ken (JP); Sakuraba, Masao, Sendai-shi, Miyagi-ken (JP)
(74) Representative: Hertz, Oliver, Dr.

(57) **Abstract**

A semiconductor device is disclosed which allows for ease of fabrication of CMOS LSI chips and is adapted to increase the mobility of electrons and holes. The semiconductor device comprises a substrate (8), an insulating layer (7) formed over the substrate, and a stacked Si/SiGe/Si region comprising a first layer (3, 6) of Si, a layer (2, 5) of SiGe, and a second layer (1, 4) of Si which are sequentially formed in this order on the insulating layer. The topmost second layer (1, 4) of Si and the layer of SiGe are strained due to the difference in lattice constant between each layer in the stacked Si/SiGe/Si region.
An n-MOSFET (17) and a p-MOSFET (18) are formed in the stacked region. The n-MOSFET has a surface channel consisting of the second Si layer, whereas the p-MOSFET has a double channel of a buried channel consisting of the SiGe layer and a surface channel consisting of the second Si layer.

## Description

The present invention relates to a semiconductor device structure suitable for use with complementary MOS field-effect transistors (CMOSFETs) and more specifically to a semiconductor device in which an n-channel MOSFET and a p-channel MOSFET are formed in stacked Si/SiGe/Si layers.

This type of semiconductor device makes remarkable advances in the Si-CMOS technology, which is the main technology to manufacture integrated circuits such as LSI chips, and can be used suitably in LSI chips specially adapted for information communications, information processing, and various electronic systems.

With the advance of electronic communications and information systems, the demand has further increased for increasing the speed of and reducing the power dissipation of LSI chips used. Conventionally, CMOS LSI chips have been used as low power dissipation chips, but they have increasing requirements for higher speeds and higher performance.

As a structure for increasing the speed and performance of semiconductor devices, the strained Si/SiGe structure is known which has an effect of improving the mobility of electrons and holes within the strained Si layer. The effect is obtained by imparting to the Si layer strain based on the difference in lattice constant between Si and SiGe and thereby changing the energy band structure of the Si layer.

As an instance, there has been proposals for the formation of an n-MOSFET and a p-MOSFET in a bulk Si substrate having a strained Si layer (for example, C. K. Maiti et al, "Strained-Si heterostructure field effect transistors," Semicond. Sci. Techno. Vol. 13, pp. 1225 - 1246, 1998).

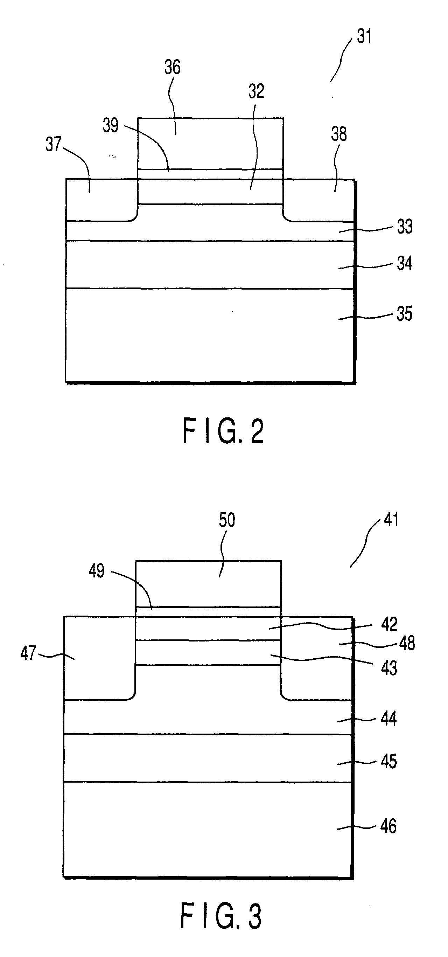

According to such a prior art technique, in fabricating an n-MOSFET having a strained Si layer, such a stacked structure as shown in FIG. 2 is used which consists of a strained Si layer 32, a non-strained SiGe layer 33, an SiGe graded buffer layer 34, and an Si substrate 35 (e.g., 1994 IEDM tech. Dig. pp. 373 - 376). And a source region 37, a drain region 38, a gate oxide film 39 and a gate electrode 36 are formed to finish an n-MOSFET 31.

For a p-MOSFET, on the other hand, a stacked structure therefor is composed, as shown in FIG. 3, of a strained Si layer 42, a strained SiGe layer 43, a non-strained SiGe layer 44, an SiGe graded buffer layer 45, and an Si substrate 46 (e.g., 1995 IEDM Tech. Dig. pp. 517 - 520). Using such a stacked structure, a source drain 47, a drain region 48, a gate oxide film 49 and a gate electrode 50 are formed to obtain a p-MOSFET 41.

The n-MOSFET 31 and the p-MOSFET 41 differ in the stacked structure; in other words, they cannot be fabricated using the same stacked structure. The prior art technique is therefore difficult to use for the manufacture of CMOS integrated circuits.

As another prior art, there has been a proposal for an n-MOSFET and a p-MOSFET utilizing the effect of improving the carrier mobility by strained Si (for instance, 1999 IEDM Tech. Dig. pp. 934 - 936). In this prior art, in the stacked structure of a non-strained SiGe layer, an SiGe buffer layer, and an Si substrate, a lot of oxygen ions are introduced into the non-strained SiGe layer to form a buried oxide film. A strained Si layer is then epitaxially grown on the non-strained SiGe layer to form the strained Si/non-strained SiGe structure (SOI (silicon on insulator) structure).

To form the buried oxide film in the SiGe layer, this structure needs a heat treatment at 1350°C after the injection of oxygen ions. It is therefore difficult to form the Ge-rich SiGe layer of good crystal quality. In addition, it is difficult to form very thin Si and SiGe layers of quality sufficient to achieve the advantages of the SOI structure.

It is therefore an object of the present invention to provide a semiconductor device which allows for ease of fabrication of CMOS LSI and super LSI chips and permits the mobility of electrons and holes in n- and p-MOS devices to be increased so that the channel current in each device is increased and consequently the performance thereof is upgraded.

It is another object of the present invention to provide a semiconductor device which permits parasitic capacitance associated with its substrate to be reduced for faster operation.

To implement very high speed, low power dissipation CMOS LSI chips, the present invention provides a semiconductor device which allows for ease of CMOS implementation of LSI chips by forming n- and p-MOS devices using the same stacked strained Si/strained SiGe/Si layers. In the n-MOS device, the topmost strained Si layer has the effect of increasing the mobility of electrons, thus enhancing the performance thereof. On the other hand, the p-MOS device has a double channel structure of the top strained Si layer and the strained SiGe layer and the topmost strained Si layer has the effect of increasing the mobility of holes, thus enhancing the performance thereof.

A semiconductor device of the present invention comprises: a substrate; an insulating layer formed over the substrate; a stacked Si/SiGe/Si region in which a first layer of Si, a layer of SiGe and a second layer of Si are sequentially formed on the insulating layer, the topmost second layer of Si and the layer of SiGe being strained based on the difference in lattice constant between each layer in the stacked Si/SiGe/Si region; and an n-MOSFET and a p-MOSFET formed in the stacked Si/SiGe/Si region. The n-MOSFET has the surface channel consisting of the second strained layer of Si, and the p-MOSFET has a double channel of the buried channel consisting of the strained layer of SiGe and the surface channel consisting of the second strained layer of Si.

Each of the layer of SiGe and the second layer of Si may be formed by means of chemical vapor deposition.

The layer of SiGe may contain carbon atoms.

The substrate may be an Si monocrystalline substrate.

In the semiconductor device of the present invention, the n- and p-MOS devices are formed in the same stacked region, thus providing easy implementation of CMOS integrated circuits. The n-MOS device operates with the topmost strained Si layer as the surface channel and the strained Si layer has the effect of increasing the mobility of electrons, thus allowing the drain current to be increased to achieve enhanced performance of the device. The p-MOS device operates on the double channel and the topmost strained Si layer and the underlying strained SiGe layer have the effect of increasing the mobility of holes, thus allowing the drain current to be increased and enhanced performance of the device to be achieved.

This summary of the invention does not necessarily describe all necessary features so that the invention may also be a sub-combination of these described features.

The invention can be more fully understood from the following detailed description when taken in conjunction with the accompanying drawings, in which:
FIG. 1 is a schematic illustration of a semiconductor device embodying the present invention;
FIG. 2 shows the structure of a conventional n-MOSFET; and
FIG. 3 shows the structure of a conventional p-MOSFET.

Hereinafter, the present invention will be described in detail in terms of a specific embodiment shown in the accompanying drawing. The description that follows is directed to an embodiment of the present invention and given for understanding of general principles of the present invention. Therefore, the present invention is not limited to the disclosed embodiment.

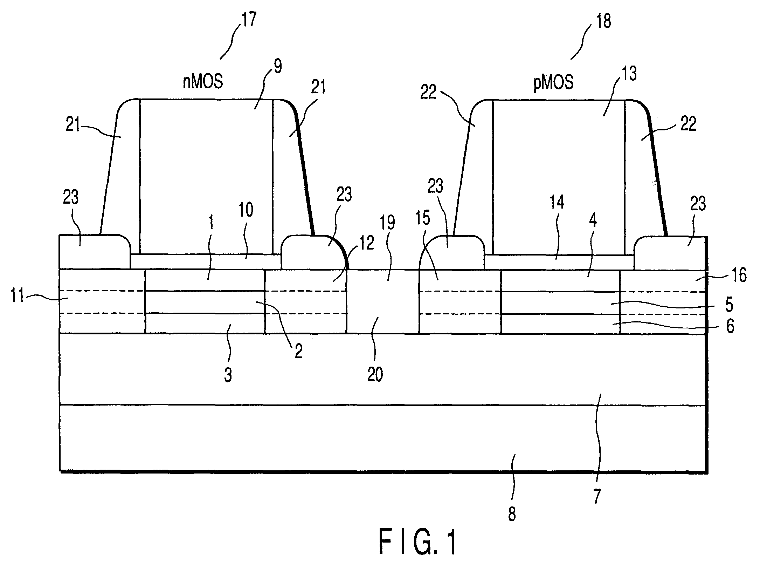

A semiconductor device embodying the present invention is illustrated in FIG. 1. On an insulating layer formed as a buried oxide layer 7 are formed stacked layer structures comprising strained Si layers 1 and 4, strained SiGe layers 2 and 5 and Si layers 3 and 6, the corresponding layers being formed in the same manufacturing step. The operating regions of an n-MOSFET 17 and a p-MOSFET 18 are formed in the stacked structure regions.

The top Si layers 1 and 4 and the underlying SiGe layers 2 and 5 (this is allowed to contain C) each have strain based on the difference in lattice constant between the Si layers 1 and 4 and the SiGe layers 2 and 5 and between the SiGe layers 2 and 5 and the Si layers 3 and 6. The difference in lattice constant between pure single crystal of Si and pure single crystal of Ge is approximately 4.2 %. Strain resulting from controlling the ratio of compositions in SiGe so that lattice constants of adjacent layers have a difference of 0.7 to 1 % and preferably about 0.7 % exhibits a significant improvement in carrier mobility.

To improve the mobility of electrons or holes in each strained layer, it is desirable to set the thickness of each of the stacked layers such that the Si layers 3 and 6 is less than or equal to 100 nm, the strained SiGe layers 2 and 5 is 5 to 20 nm and preferably 5 to 10 nm, and the strained Si layers 1 and 4 is 2 to 5 nm.

The insulating layer 7 and the overlying Si layers 3 and 6 can be formed by means of, for example, the SIMOX (Separation by Implanted Oxygen) method or the wafer lamination technique as with normal SOI (Silicon-On-Insulator) substrates. The SOI substrate in this embodiment comprises an Si monocrystalline substrate 8, the Si oxide layer 7 formed over the substrate, and the first thin Si monocrystalline layers 3 and 6 formed on the oxide layer 7.

The SiGe layers 2 and 5 and the overlying second Si layers 1 and 4 are epitaxially grown on the first monocrystalline Si layers 3 and 6 by means of chemical vapor deposition by way of example. These layers can also formed by other methods such as evaporation. In the case of chemical vapor deposition, standard semiconductor manufacturing equipment and processes are available for vapor deposition of each layer. For example, Si can be deposited using a gas of SiH₄. For Ge, a gas of GeH₄ can be used. A mixed gas which contains those gases and a normal carrier gas in a given ratio is introduced into the vapor deposition equipment where thermal decomposition of SiH₄ and/or GeH₄ takes place to form layers.

In the invention, the SiGe layers 2 and 5 is formed to contain 50% silicon and 50% germanium as an example. Making the Ge/Si ratio too great results in the lattice constant of SiGe mixed crystal becoming too great in comparison with that of Si and consequently in strain becoming too large. To form this layer, it is also possible to add C atoms to Si and Ge atoms. The lattice constant of C is considerably smaller than that of Ge. By adding up to 2% carbon, the lattice constant of SiGe mixed crystal can be adjusted to impart optimum strain to the top Si layer and the SiGe layer. For example, the addition of C can be made by adding a predetermined amount of CH₃SiH₃ to the above mixed gas.

In the present embodiment to form CMOSFETs 17 and 18, each of the stacked Si/SiGe/Si layers can be formed as one which is not artificially doped with any impurity. To achieve electrical properties required of MOS transistors, however, given layers may be doped with p- or n-type impurities at a desired dose through, for example, ion implantation at the time of vapor deposition or subsequent thereto.

In the invention, the n-MOSFET 17 operates using the surface channel formed in the top strained Si layer 1. The conduction band in the top Si layer 1 is low in level than that in the SiGe layer 2; thus, no buried channel is formed in the SiGe layer, and the surface channel is formed in the top strained Si layer 1. The mobility of electrons in the top strained Si layer 1 is about 1.8 times higher than that in usual single crystals.

In the p-MOSFET 18, the surface inversion layer is formed in the top Si layer 4, forming the surface channel. In addition, since the valence band in the strained SiGe layer 5 for holes is lower than in level than that in the top Si layer 4, holes are confined in the SiGe layer 5, thereby forming the buried channel. The mobility of holes in the strained SiGe layer 4 is increased by a factor of 1.4 to 1.8.

Accordingly, the p-MOSFET 18 operates through a double channel: the buried channel in the strained SiGe layer 5 (or C-containing strained SiGe layer) and the surface channel in the top strained Si layer 4. Experiments confirmed that the p-MOSFET 18 has at least two times the mutual conductance of a p-MOSFET formed of monocrystalline silicon alone.

The n⁺ source and drain regions 11 and 12 of the n-MOSFET 17 are formed by ion implanting arsenic or phosphorous at a high dose through the use of selective masking into selected portions of the region where the Si layer 1, the SiGe layer 2 and the Si layer 3 have been stacked and then performing an annealing operation. As an alternative to ion implantation, diffusion may be used to form the source and drain regions 11 and 12.

As with the n-MOSFET, the p⁺ source and drain regions 15 and 16 of the p-MOSFET 17 are also formed by ion implanting boron at a high dose and then performing an annealing operation. In this case as well, diffusion may be used in place of ion implantation.

An oxide layer 19 that isolates the n-MOSFET 17 and the p-MOSFET 18 from each other can be formed by etching away that selected portion of the stacked Si/SiGe/Si structure in which the oxide layer is to be formed to form a trench 20 and then filling the trench with an insulating material, such as SiO2, through the use of standard processes.

Gate oxide films 10 and 14, gate electrodes 9 and 13, gate electrode sidewalls 21 and 22 and source and drain electrodes 23 can be formed using standard CMOS manufacturing processes; thus, a description of manufacturing processes therefor is omitted here.

Although the present invention has been described in terms of a CMOS integrated circuit, the principles of the invention are equally applicable to semiconductor devices including both n-MOSFETs and p-MOSFETs.

The present invention has the following advantages: Since the n-MOSFET 17 and the p-MOSFET 18 are formed in the same multilayered structure as shown in FIG. 1, application to CMOS integrated circuits can be made readily. The n-MOSFET 17 has the channel in the top strained Si layer 1 and hence operates as a surface channel type of MOSFET. The increased electron mobility by strained Si allows the drain current and the performance of the device to be increased. On the other hand, the p-MOSFET 18 has a double channel and the hole mobility is increased by the top strained Si 14 and the strained SiGe 5, allowing the drain current and the device performance to be increased. The parasitic capacitance associated with the substrate is small, allowing faster operation.

Although the embodiment of the present invention has been described and illustrated, it is apparent that the invention may be practiced or embodied in other ways without departing from the scope and spirit thereof.

## Claims

1. A semiconductor device **characterized by** comprising:
a substrate (8);
an insulating layer (7) formed over the substrate;
a stacked Si/SiGe/Si region in which a first layer (3, 6) of Si, a layer (2, 5) of SiGe and a second layer (1, 4) of Si are sequentially formed on the insulating layer, the topmost second layer (1, 4) of Si and the layer (2, 5) of SiGe being strained based on the difference in lattice constant between each layer in the stacked Si/SiGe/Si region; and
an n-MOSFET and a p-MOSFET formed in the stacked Si/SiGe/Si region, the n-MOSFET having a surface channel consisting of the second strained layer (1) of Si, and the p-MOSFET having a double channel of a buried channel consisting of the strained layer (5) of SiGe and a surface channel consisting of the second strained layer (4) of Si.

2. The semiconductor device according to claim 1, **characterized in that** each of the layer (2, 5) of SiGe and the second layer (1, 4) of Si is formed by means of chemical vapor deposition.

3. The semiconductor device according to claim 2, **characterized in that** the layer (2, 5) of SiGe contains carbon atoms.

4. The semiconductor device according to claim 1, **characterized in that** the substrate (8) is an Si monocrystalline substrate.
